# EUROPEAN PATENT APPLICATION

(11) **EP 3 240 379 A1**
(43) Date of publication of application: **01.11.2017**
(21) Application number: 15871947.6
(22) Date of filing: 22.12.2015
(51) Int. Cl.: H05K 5/04, B29C 45/76

(54) **COMMUNICATION EQUIPMENT METAL HOUSING AND PREPARATION METHOD THEREFOR**

(30) Priority: 26.12.2014 CN 201410829039
(71) Applicant: BYD Company Limited, Shenzhen, Guangdong 518118 (CN)
(72) Inventor: LI, Konglin, Shenzhen Guangdong 518118 (CN); ZHAO, Guiwang, Shenzhen Guangdong 518118 (CN); GUO, Lifen, Shenzhen Guangdong 518118 (CN); LIU, Chencen, Shenzhen Guangdong 518118 (CN); DONG, Mingjie, Shenzhen Guangdong 518118 (CN)
(74) Representative: Gulde & Partner
(86) International application number: PCT/CN2015/098305
(87) International publication number: WO 2016/101879

(57) **Abstract**

The present disclosure provides a method of manufacturing a metal shell of a communication equipment and a metal shell of a communication equipment thus obtained, the method includes steps of: 1) performing a first injection molding on a non-slit region of an inner surface of a metal substrate; 2) forming at least one slit on a slit region of the inner surface of the metal substrate; and 3) performing a second injection molding on the slit region of the inner surface of the metal substrate.

## Description

### FIELD

Examples of the present disclosure generally relate to a metal shell of communication equipment and a method of manufacturing the same.

### BACKGROUND

For various portable electronic communication equipments, such as cell phone, notebook computer, tablet computer, etc., a metal shell may have a better appearance and better texture than a plastic shell, in addtion, the metal shell may have a better wear resistance and pressure resistance. Thus, adopting metal shell as a shell of electronic communication equipment will be a tendency in the future. However, current technology may restrict this develop tendency, because metal has an effect of electromagnetic signal shielding, thus many manufacturers still choose plastic shell as shell of electronic communication equipment, and some manufacturers adopt technology that separates the metal via a plastic bar to avoid electromagnetic signal shielding.

However, although the technology that separates the metal via a plastic bar could avoid electromagnetic signal shielding, the whole shell is separated into pieces via seening from apperance, and loses its appearance integrity.

### SUMMARY

The present disclosure seeks to solve the problem stated above and provides a metal shell of communication equipment which could be suitable for various antennas and have an effect of integration appearance, and method of manufacturing the same.

Thus, in order to achieve objectives stated above, the present disclosure provides a method of manufacturing a metal shell of a communication equipment, the method includes steps of:
1) performing a first injection molding on a non-slit region of an inner surface of a metal substrate;
2) forming at least one slit on a slit region of the inner surface of the metal substrate; and
3) performing a second injection molding on the slit region of the inner surface of the metal substrate.

The present disclosure further provides a metal shell of communication equipment obtained via the method stated above.

With the method of the present disclosure, a first injection molding is first performed on the non-slit region of the inner surface of the metal substrate to form a plastic layer on the non-slit region of the inner surface of the metal substrate, so as to provide a supporting for the following slit machining, then deformation of the slit during slit machining may be avoided. Moreover, when machining the slit, a metal residual may be discharged through a vacancy reserved by the first injection molding (namely "space formed by removing the shielding member" stated below, or the slit region of the inner surface of the metal substrate), thus the metal residual could be prevented from staying in the slit, which may influence passing of electromagnetic wave. In addition, the vacancy reserved may be further filled through the second injection molding, which could prevent the slit from being deformed during the process of surface decorating, thus, after surface decorating process, flat and consistent of the appearance of the metal shell could be guaranteed so as to obtain an effect of integration appearance.

These and other aspects and advantages of examples of the present disclosure will be described in detail with reference to the following detail description.

### BRIEF DESCRIPTION OF THE DRAWINGS

The drawings are used for further comprehending the present disclosure, it should constitute as one part of the description, and used to explain the present disclosure together with the specific embodiments, however it should not be constructed as limit to the present disclosure.
Fig. 1 is a flow schematic view of a method of manufacturing a metal shell of communication equipment according to one embodiment of the present disclosure;
Fig. 2 is a schematic view of a metal shell of communication equipment according to one embodiment of the present disclosure; and
Fig. 3 is a schematic view of a metal shell of communication equipment obtained of Example 1.

### Reference number:

1 metal layer
2 first plastic layer
3 slit
4 second plastic layer
5 decorative layer
6 plastic layer

### DETAILED DESCRIPTION

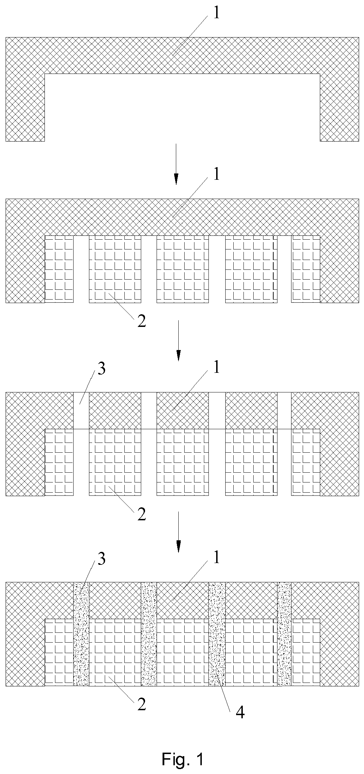

Reference will be made in detail to examples of the present disclosure. The examples described herein are explanatory and illustrative, which are used to generally understand the present disclosure. The examples shall not be construed to limit the present disclosure. According to an aspect of examples of the present disclosure, the present disclosure provides a method of manufacturing a metal shell of communication equipment, as shown in Fig. 1, the method includes steps of:
1) performing a first injection molding on a non-slit region of an inner surface of a metal substrate 1 so as to form a first plastic layer 2 on the non-slit region of the inner surface of the metal substrate 1;
2) forming at least one slit 3 on a slit region of the inner surface of the metal substrate 1; and
3) performing a second injection molding on the slit region of the inner surface of the metal substrate so as to form a second plastic layer 4 on the inner surface of the metal substrate 1.

According to embodiments of the present disclosure, the communication equipment could be, for example, cell phone, tablet computer, notebook computer, bluetooth headset or bracelet.

In embodiments of the present disclosure, the inner surface of the metal shell is defined as, when the metal shell is assembled into communication equipment, a surface of the metal shell that faces toward inside of the communication equipment. It should be noted that the outer surface of the metal shell is defined as, when the metal shell is assembled into communication equipment, a surface of the metal shell that faces toward outside of the communication equipment. Besides, the inner and outer surfaces of the metal substrate used for manufacturing the metal shell could also be applied to the definition above.

In embodiments of the present disclosure, the "slit region" refers to a region, which corresponds to an antenna of the communication equipment, of the metal substrate. The "non-slit region" refers to a region, other than the "slit region", of the metal substrate.

Besides, for the size of the slit region, it could be appropriately selected by one with ordinary skills in the art according to the installation range of the antenna of the communication equipment.

In embodiments of the present disclosure, the material of the metal substrate could be any metal that commonly used in communication equipment in the art, for example, aluminum alloy, stainless steel, magnesium alloy or titanium alloy.

In embodiments of the present disclosure, there is no particular limitation for the thickness of the metal substrate, it could be regulated by one with ordinary skills in the art according to a specific communication equipment. For example, the metal substrate may have a thickness of about 0.1 millimeters to about 0.8 millimeters, preferably about 0.3 millimeters to about 0.6 millimeters.

In embodiments of the present disclosure, there is no particular limitation for the method of the first injection molding performed on the non-slit region of the inner surface of the metal substrate, for example, in some embodiments, the first injection molding could be performed via a vertical injection molding machine.

In embodiments of the present disclosure, when performing the first injection molding, in order to effectively avoid injection molding on the non-slit region, in some embodiments, the first injection molding is performed by adhering a shielding member on the slit region of the inner surface of the metal substrate, and then performing injection molding on the non-slit region of the inner surface of the metal substrate.

In embodiments of the present disclosure, the shielding member could be adhered on the inner surface of the metal substrate via an adhesive, the adhesive could be any commonly used adhesive in the art, for example, the adhesive could be 502 glue.

In embodiments of the present disclosure, the shielding member is used for shielding the slit region during the first injection molding. There is no particular limitation for the specific species of the shielding member, for example, the shielding member could be a plastic member or a metal member.

In embodiments of the present disclosure, there is no particular limitation of the thickness of the shielding member, as long as the shielding member could meet the function stated above. For example, the shielding member may have a thickness of about 0.5 millimeters to about 2 millimeters, preferably about 1.2 millimeters to about 1.8 millimeters.

In embodiments of the present disclosure, when the shielding member includes a metal member, the shielding member may be made of aluminum alloy, stainless steel or titanium alloy. When the shielding member includes a plastic member, the shielding member may be made of polyethylene, polypropylene, polyacetal, polystyrene, modified polyphenyl ether, phenolic resin, polyethylene glycol terephthalate, polybutylene terephthalate, polyethylene naphthalate, polyphenylene sulfide, polyimide, polyamide-imide, polyetherimidem, polysulfone, polyether sulfone, polyether ketone, polyether ether magnesium, polycarbonate, polyamide, acrylonitrile-butadiene-styrene copolymer or combinations thereof.

In embodiments of the present disclosure, in order to improve compactness between the plastic layer 3 and the metal substrate and improve strength of the metal shell obtained, prior to performing the first injection molding, the method further includes: performing a first roughing treatment on an injection molding region of the first injection molding, or in other words, performing the first roughing treatment on the non-slit region of the inner surface of the metal substrate.

In embodiments of the present disclosure, the first roughing treatment is performed by steps of: a) contacting the inner surface of the metal substrate with a hydrochloric acid solution having a concentration of about 2wt% to about 20wt% for about 1 minute to about 5 minutes under a temperature of about 10 Celsius degrees to about 35 Celsius degrees, and then dipping the metal substrate under water for about 1 minute to about 5 minutes; and b) repeating the step a) for 2 to 10 times. Or in other words, the first roughing treatment includes: contacting the inner surface of the metal substrate with a hydrochloric acid solution having a concentration of about 2wt% to about 20wt% for about 1 minute to about 5 minutes under a temperature of about 10 Celsius degrees to about 35 Celsius degrees, and then taking out the metal substrate and dipping the metal substrate under water for about 1 minute to about 5 minutes; and repeating the above steps for 2 to 10 times.

In embodiments of the present disclosure, with the first roughing treatment, a plurality of micro-concavities may be at least formed on an inner surface of the slit region of the inner surface of the metal shell, then the compactness between the plastic layer 3 obtained after injection molding and the metal substrate may be improved.

In embodiments of the present disclosure, the first injection molding could be performed under commonly used conditions. In some embodiments, the first injection molding is performed under conditions of: an injection pressure of about 1600bar to about 2400bar, a maintaining pressure of about 800bar to about 1400bar, a temperature of upper and lower mould of about 80 Celsius degrees to about 150 Celsius degrees, and an injection time of about 0.5 seconds to about 2 seconds. In some other embodiments, the first injection molding is performed under conditions of: an injection pressure of about 1800bar to about 2200bar, a maintaining pressure of about 900bar to about 1300bar, a temperature of upper and lower mould of about 90 Celsius degrees to about 140 Celsius degrees, and an injection time of about 0.8 seconds to about 1.6 seconds.

According to embodiments of the present disclosure, a resin used in the first injection molding could be any commonly used resin in the art, for example, the resin could be polyethylene, polypropylene, polyacetal, polystyrene, modified polyphenyl ether, polyethylene glycol terephthalate, polybutylene terephthalate, polyethylene naphthalate, polyphenylene sulfide, polyimide, polyamide-imide, polyetherimidem, polysulfone, polyether sulfone, polyether ketone, polyether ether magnesium, polycarbonate, polyamide, acrylonitrile-butadiene-styrene copolymer or combinations thereof.

According to embodiments of the present disclosure, in order to further improve mechanical strength of the metal shell obtained, in some embodiments, the material used in the first injection molding includes a mixture of resin and glass fiber. In some other embodiments, the resin of the mixture includes polyethylene glycol terephthalate, polyphenylene sulfide, polycarbonate or polyamide, and based on the weight of the mixture, the glass fiber has a content of about 1wt% to about 50wt%, preferably about 25wt% to about 35wt%.

According to embodiments of the present disclosure, a first plastic layer 2 combined with the metal substrate 1 is obtained after the first injection molding. For the thickness of the first plastic layer 2, it could be appropriately selected by one with ordinary skills in the art according to a design need of product thickness, for example the thickness of the first plastic layer 2 may be about 0.1 millimeters to about 2 millimeters, preferably about 0.4 millimeters to about 1.1 millimeters.

According to embodiments of the present disclosure, with supporting of the first plastic layer 2 to the metal substrate 1, a deformation of the slit 3 may be avoided during manufacturing process of the slit.

According to embodiments of the present disclosure, prior to forming the slit, the shielding member should be removed from the metal substrate. In embodiments of the present disclosure, removing the shielding member further includes removing the adhesive used for adhering the shielding member. By removing space formed by removing the shielding member, a metal residual may be discharged during slit machining, thus the metal residual could be prevented from staying in the slit, which may influence passing of electromagnetic wave.

According to embodiments of the present disclosure, at least one slit should be formed on the metal substrate so as to guarantee signal transmission between the antenna and outside environment to realize communication. For the slit, the slit may have a width of about 5 microns to about 100 microns, preferably about 15 microns to about 60 microns. The slit may have a length of about 2 millimeters to about 300 millimeters, preferably about 50 millimeters to about 150 millimeters. In some embodiments, a distance between two adjacent slits is about 0.1 millimeters to about 30 millimeters, preferably about 0.5 millimeters to about 15 millimeters. Besides, in embodiments of the present disclosure, there are no particular limitations for the number and shape of the slit, as long as the slit could realize communication. For example, the number of the slit may be 1 to 20, preferably 5 to 15, and the slit may have a shape of linear, curvilinear, square wave linear or sawtooth linear, preferably linear.

Moreover, for the specific width, distance, length, number of the slit, they could be regulated by those skilled in the art according to category and frequency of communication signal of actual need in these above ranges. The specific regulating method is well known by those skilled in the art, therefore detailed description is omitted herein.

According to embodiments of the present disclosure, in step 2), the slit is formed by cutting the metal substrate. In other words, the slit could be formed by cutting the region of the metal substrate on where the shield member is adhering (namely the slit region). There is no particular limitation for method of the cutting, as long as the slit obtained could meet these requirement stated above, it could be any common method in the art. In some embodiments, the method of the cutting is at least one selected from a group consisting of laser cutting, electron beam cutting, waterjet cutting and wire-electrode cutting.

According to embodiments of the present disclosure, when adopting these cutting methods stated above, these specific operations and conditions could be common operations and conditions in the art, for example, the conditions of the laser cutting may include: a power of about 50W to about 200W, a cutting speed of about 10mm/s to about 5000mm/s, a frequency of about 10kHz to about 200kHz, a output wave length of about 250 nanometers to about 1064 nanometer. With the above laser cutting, the slit formed may generally have a width of about 20microns to about 80microns.

According to embodiments of the present disclosure, the electron beam cutting includes: cutting under an environment having a vacuum degree of about 10⁻³-10⁻⁴Pa, a current of about 5mA to about 10mA, a power density of about 10⁶-10⁸W/cm². With the above electron beam cutting, the slit formed may generally have a width of about 30microns to about 150microns.

According to embodiments of the present disclosure, the conditions of the wire-electrode cutting may include: a feed speed of about 2mm/min to about 15mm/min, a peak current of about 0.8A to about 1.8A, a voltage of about 5V to about 110V, a pulse width of about 2µs to about 6µs, and a pulse distance of about 6µs to about 30µs.

According to embodiments of the present disclosure, in order to avoid deformation of the slit 3 during surface decorating, after forming the slit 3 on the metal substrate 1, a second injection molding is performed on the slit region of the inner surface of the metal substrate 1.

With the second injection molding, a second plastic layer 4 is formed on the slit region of the metal substrate 1, the second plastic layer 4 could partially or totally extend into the slit 3 (that is, the second plastic layer could be partially or totally filled in the slit).

According to embodiments of the present disclosure, for the thickness of the second plastic layer, it could be appropriately selected by those skilled in the art according to design need of the product thickness, for example, the second plastic layer may have a thickness of about 0.1millimeters to about 2millimeters, preferably about 0.4millimeters to about 1.1millimeters.

According to embodiments of the present disclosure, considering aesthetic aspect of the metal shell, in some embodiments, the first plastic layer and the second plastic layer have a same thickness, that a surface of the plastic layer formed on the inner surface of the metal substrate is flat and uniform.

According to embodiments of the present disclosure, a resin used in the second injection molding and method and conditions of a second roughing treatment performed before the second injection molding are the same as the first injection molding, detailed description is omitted herein.

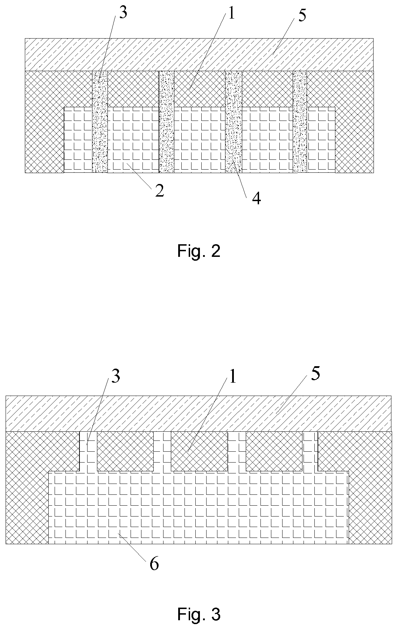

According to embodiments of the present disclosure, in order to enhance aesthetic effect of the metal shell, as shown in Fig. 2, a decorative layer 5 is formed on an outer surface of the metal substrate 1. The decorative layer 5 may be formed by common method and conditions used in the art, for example, in some embodiments, the decorative layer is formed via electrophoresis, micro-arc oxidation, anodic oxidation, hard anodic oxidation, spraying or combinations thereof.

According to embodiments of the present disclosure, a thickness of the decorative layer could be varied in a relatively large range, in some embodiments, the thickness of the decorative layer is about 5 microns to about 60 microns. The decorative layer could be any common decorative layer of various electronic product shell, for example, the decorative layer could be aluminium oxide layer, epoxy coating layer or acrylic resin coating layer.

According to embodiments of the present disclosure, the decorative layer could be formed via anodic oxidation, the conditions of the anodic oxidation could be common conditions known by those skilled in the art, for example, the conditions of anodic oxidation may include: a bath solution of sulfuric acid having a concentration of about 150g/L to about 210g/L, a voltage of about 10V to about 15V, a current density of about 1 to about 2A/dm², a temperature of about 10Celsius degrees to about 20Celsius degrees, an anodic oxidation time of about 20minutes to about 60minutes, a sealing bath solution (for example, NiSO₄ aqueous solution) having a concentration of about 1g/L to about 10g/L, a sealing temperature of about 50Celsius degrees to about 95Celsius degrees, a sealing time of about 10minutes to about 50minutes. The decorative layer formed via the anodic oxidation stated above generally has a thickness of about 10microns to about 30microns.

According to embodiments of the present disclosure, the decorative layer could be formed via micro-arc oxidation, the conditions of the micro-arc oxidation could be common conditions known by those skilled in the art, for example, the conditions of micro-arc oxidation may include: a pH of about 6-12, a voltage of about 0V to about 800V, a current density of about 1 A/dm² to about 10A/dm², a temperature of about 15 Celsius degrees to about 60 Celsius degrees, a time of about 10 minutes to about 60 minutes, a sealing bath solution of water, a sealing temperature of about 70Celsius degrees to about 90Celsius degrees, a sealing time of about 1 minutes to about 10minutes. The decorative layer formed via the micro-arc oxidation stated above generally has a thickness of about 10microns to about 50microns.

According to embodiments of the present disclosure, the decorative layer could be formed via electrophoresis, the conditions of the electrophoresis could be common conditions known by those skilled in the art, for example, the conditions of electrophoresis may include: cathode electrophoresis: a voltage of about 20V to about 60V, a pH of about 4-6, a temperature of about 15Celsius degrees to about 30Celsius degrees, a time of about 20seconds to about 60 seconds; anode electrophoresis: a voltage of about 40V to about 100V, a pH of about 6-8, a temperature of about 15Celsius degrees to about 30Celsius degrees, a time of about 40seconds to about 90 seconds; a baking temperature of about 120Celsius degrees to about 200Celsius degrees, and a baking time of about 30minutes to about 60minutes. The decorative layer formed via the electrophoresis stated above generally has a thickness of about 5microns to about 35microns.

According to embodiments of the present disclosure, the decorative layer could be formed via spraying, the conditions of the spraying could be common conditions known by those skilled in the art, for example, the conditions of spraying may include: a static high voltage of about 60kV to about 90kV, a static current of about 10µA to about 20µA, a velocity pressure of about 0.3Mpa to about 0.55Mpa, an atomizing pressure of about 0.33Mpa to about 0.45Mpa, a transporting velocity of about 4.5m/min to about 5.5m/min, a curing temperature of about 150Celsius degrees to about 220Celsius degrees, a curing time of about 30minutes to about 180minutes.

According to another aspect of the present disclosure, the present disclosure further provides a metal shell of communication equipment obtained via the method mentioned above.

According to the metal shell of communication equipment, the metal shell of communication equipment has a decorative layer which surface is flat and consistent, and has an effect of integrity.

Detailed descriptions of the present disclosure will be given below by referring to Example.

### Example 1

### 1) First injection molding

An aluminum alloy (purchased from DONGGUAN GANGXIANG METAL MATERIAL CO., LTD. 6061, thickness of 0.4millimeters) is cut to form a metal substrate having a size of 15millimetes*80millimeters. Then, a plastic piece (phenolic resin piece having a thickness of 1.4millimeters) is adhered on a region of inner surface of the metal substrate on where a slit will be formed via 502 glue. And then the metal substrate adhering with the phenolic resin piece is subjected to oil removing, water washing, alkali etching, water washing, acid etching and water washing treatment, and then dipped into a pre-treating solution (carbamic acid ester aqueous solution) for 5 minutes to conduct pre-treatment, and then the metal substrate is dried under 80Celsius degrees for 20minutes so as to finish a pre-treatment of injection molding.

Then 500mL hydrochloric acid solution having a concentration of 10wt% is prepared in a beaker and then the hydrochloric acid solution is placed in a thermostatic bath having a temperature of 25 Celsius degrees to warm to 25 Celsius degrees, and then the metal substrate adhering with the phenolic resin piece is dipped in the hydrochloric acid solution for 2 minutes, and then the metal substrate adhering with the phenolic resin piece is taken out and dipped in a beaker containing water for 1 minutes, taking one acid dipping and one water dipping as a circulation, the circulation is repeated for 4 times, after the last water dipping, the product is placed in an oven having a temperature of 80Celsius degrees so as to dry the product to obtain a metal substrate A11 after roughing treatment.

Then the metal substrate A11 is placed in a mould, a polybutylene terephthalate (PBT) containing 30wt% of glass fiber is injection molded on a non-adhering region(non-slit region) of the inner surface of the metal substrate (conditions of the injection molding includes: an injection pressure of 1800bar, a maintaining pressure of 1000bar, a temperature of upper and lower mould of 90 Celsius degrees and an injection time of 0.8 seconds) so as to form a first plastic layer (having a thickness of 0.6millimeters), thus a metal substrate A12 combined with the first plastic layer is obtained.

### 2) Slit machining

The adhesive and plastic piece of the metal substrate A12 is removed. Slit machining is performed by adopting a laser machine (FM20D laser machine produces by SHENZHEN GDLASER TECHNOLOGY CO., LTD) on region adhering the shielding member of the metal substrate (namely the slit region) (there are 9 slits formed, the slit has a shape of linear), the slit has a width of 20 microns and a length of 30 millimeters, a distance between two adjacent slits is 1 millimeters. A power of the laser is 50W, a cutting speed is 50mm/s, a frequency is 20kHz and a wave length is 1064 nanometers. Then a metal substrate A13 with slit is obtained.

### 3) Second injection molding

The second injection molding, adopting the same method of the first injection molding, is performed on a non-injection molded region (namely slit region) of the inner surface of the metal substrate A13 so as to form a second plastic layer (having a thickness of 0.6millimeters). Thus a metal substrate A14 combined with a flat and consistent plastic layer is obtained, the second plastic layer is fully filled in the slit.

### 4) Forming surface decorative layer via anodic oxidation

The metal substrate A14 is subjected to alkali etching, water washing, acid etching and water washing treatment, then the metal substrate A14 is dipped in an electrolytic bath containing H₂SO₄ aqueous solution having a concentration of 180g/L, taking the metal substrate A14 as anode and a stainless steel as cathode, the anodic oxidation is performed under a voltage of 15V, a current density of 1A/dm², a temperature of 19 Celsius degrees for 40 minutes. And then the metal substrate A14 is taken out and cleaned up via ultrasonic wave to avoid hidden acid in the slit which may influence following dyeing. Then the slit is totally covered by the decorative layer and invisible by naked eyes.

The metal substrate A14 after anodic oxidation is dipped in an acidic dye solution (dyestuff: TAC BLACK-SLH, purchased from OKUNO CHEMICAL INDUSTRIES CO., LTD) to conduct dyeing for 10 minutes, the acidic dye solution has a concentration of 5g/L, a pH of 5.5, a temperature of 50 Celsius degrees. Then the metal substrate A14 is taken out and cleaned.

Then the metal substrate A14 is dipped in a sealant (NiSO₄ aqueous solution, having a concentration of 10g/L) for 20 minutes, under a temperature of 95Celsius degrees. And then the metal substrate A14 is cleaned via pure water having a temperature of 90 Celsius degrees, and baked under 60 Celsius degrees for 15 minutes. Then the decorative layer obtained has a thickness of 20 microns. Thus a communication equipment metal shell A15, which has an effect of integrated appearance and a decorative layer having a flat surface, is obtained.

A structure of the communication equipment metal shell obtained is shown in Fig. 3. The plastic layer 6 is covered and fixed on the inner surface of the metal substrate 1, a plurality of slits 3 is formed in the metal substrate 1, the slit 3 is fully filled with the plastic layer 6, the outer surface of the metal substrate 1 is coated with the decorative layer 5, the decorative layer 5 has no groove or irregularity, the surface of the decorative layer 5 is flat.

### Example 2

### 1) First injection molding

An aluminum alloy (purchased from DONGGUAN GANGXIANG METAL MATERIAL CO., LTD. 6061, thickness of 0.6millimeters) is cut to form a metal substrate having a size of 15millimetes*80millimeters. Then, a plastic piece (phenolic resin piece having a thickness of 1.8millimeters) is adhered on a region of inner surface of the metal substrate on where a slit will be formed via 502 glue. And then the metal substrate adhering with the phenolic resin piece is subjected to oil removing, water washing, alkali etching, water washing, acid etching and water washing treatment, and then dipped into a pre-treating solution (carbamic acid ester aqueous solution) for 5 minutes to conduct pre-treatment, and then the metal substrate is dried under 80Celsius degrees for 20minutes so as to finish a pre-treatment of injection molding.

Then 500mL hydrochloric acid solution having a concentration of 2wt% is prepared in a beaker and then the hydrochloric acid solution is placed in a thermostatic bath having a temperature of 25 Celsius degrees to warm to 25 Celsius degrees, and then the metal substrate adhering with the phenolic resin piece is dipped in the hydrochloric acid solution for 5 minutes, and then the metal substrate adhering with the phenolic resin piece is taken out and dipped in a beaker containing water for 3 minutes, taking one acid dipping and one water dipping as a circulation, the circulation is repeated for 3 times, after the last water dipping, the product is placed in an oven having a temperature of 80Celsius degrees so as to dry the product to obtain a metal substrate A21 after roughing treatment.

Then the metal substrate A21 is placed in a mould, a polybutylene terephthalate(PBT) containing 25wt% of glass fiber is injection molded on a non-adhering region (non-slit region) of the inner surface of the metal substrate (conditions of the injection molding includes: an injection pressure of 2200bar, a maintaining pressure of 1200bar, a temperature of upper and lower mould of 140 Celsius degrees and an injection time of 1.5 seconds) so as to form a first plastic layer(having a thickness of 1.1 millimeters), thus a metal substrate A22 combined with the first plastic layer is obtained.

### 2) Slit machining

The adhesive and plastic piece of the metal substrate A22 is removed. Slit machining is performed by adopting a laser machine (FM20D laser machine produces by SHENZHEN GDLASER TECHNOLOGY CO., LTD) on region adhering the shielding member of the metal substrate (namely the slit region) (there are 9 slits formed, the slit has a shape of linear), the slit has a width of 40 microns and a length of 100 millimeters, a distance between two adjacent slits is 2 millimeters. A power of the laser is 200W, a cutting speed is 500mm/s, a frequency is 80kHz and a wave length is 300 nanometers. Then a metal substrate A23 with slit is obtained.

### 3) Second injection molding

The second injection molding, adopting the same method of the first injection molding, is performed on a non-injection molded region (namely slit region) of the inner surface of the metal substrate A23 so as to form a second plastic layer (having a thickness of 1.1 millimeters). Thus a metal substrate A24 combined with a flat and consistent plastic layer is obtained, the second plastic layer is fully filled in the slit.

### 4) Forming surface decorative layer via anodic oxidation

The metal substrate A24 is subjected to alkali etching, water washing, acid etching and water washing treatment, then the metal substrate A14 is dipped in an electrolytic bath containing H₂SO₄ aqueous solution having a concentration of 180g/L, taking the metal substrate A24 as anode and a stainless steel as cathode, the anodic oxidation is performed under a voltage of 15V, a current density of 1A/dm², a temperature of 19 Celsius degrees for 40 minutes. And then the metal substrate A24 is taken out and cleaned up via ultrasonic wave to avoid hidden acid in the slit which may influence following dyeing. Then the slit is totally covered by the decorative layer and invisible by naked eyes.

The metal substrate A24 after anodic oxidation is dipped in an acidic dye solution (dyestuff: TAC BLACK-SLH, purchased from OKUNO CHEMICAL INDUSTRIES CO., LTD) to conduct dyeing for 10 minutes, the acidic dye solution has a concentration of 5g/L, a pH of 5.5, a temperature of 50 Celsius degrees. Then the metal substrate A24 is taken out and cleaned.

Then the metal substrate A24 is dipped in a sealant (NiSO₄ aqueous solution, having a concentration of 10g/L) for 20 minutes, under a temperature of 95Celsius degrees. And then the metal substrate A24 is cleaned via pure water having a temperature of 90 Celsius degrees, and baking under 60 Celsius degrees for 15 minutes. Then the decorative layer obtained has a thickness of 20 microns. Thus a communication equipment metal shell A25, which has an effect of integrated appearance and a decorative layer having a flat surface, is obtained.

### Example 3

### 1) First injection molding

An aluminum alloy (purchased from DONGGUAN GANGXIANG METAL MATERIAL CO., LTD. 6061, thickness of 0.5millimeters) is cut to form a metal substrate having a size of 15millimetes*80millimeters. Then, a metal piece (stainless steel piece having a thickness of 1.5millimeters) is adhered on a region of inner surface of the metal substrate on where a slit will be formed via 502 glue. And then the metal substrate adhering with the metal piece is subjected to oil removing, water washing, alkali etching, water washing, acid etching and water washing treatment, and then dipped into a pre-treating solution (carbamic acid ester aqueous solution) for 5 minutes to conduct pre-treatment, and then the metal substrate is dried under 80Celsius degrees for 20minutes so as to finish a pre-treatment of injection molding.

Then 500mL hydrochloric acid solution having a concentration of 1.5wt% is prepared in a beaker and then the hydrochloric acid solution is placed in a thermostatic bath having a temperature of 25 Celsius degrees to warm to 25 Celsius degrees, and then the metal substrate adhering with the metal piece is dipped in the hydrochloric acid solution for 3 minutes, and then the metal substrate adhering with the phenolic resin piece is taken out and dipped in a beaker containing water for 3 minutes, taking one acid dipping and one water dipping as a circulation, the circulation is repeated for 5 times, after the last water dipping, the product is placed in an oven having a temperature of 80Celsius degrees so as to dry the product to obtain a metal substrate A31 after roughing treatment.

Then the metal substrate A31 is placed in a mould, a polybutylene terephthalate (PBT) containing 35wt% of glass fiber is injection molded on a non-adhering region (non-slit region) of the inner surface of the metal substrate (conditions of the injection molding includes: an injection pressure of 2000bar, a maintaining pressure of 1100bar, a temperature of upper and lower mould of 110 Celsius degrees and an injection time of 1 seconds) so as to form a first plastic layer (having a thickness of 0.8millimeters), thus a metal substrate A32 combined with the first plastic layer is obtained.

### 2) Slit machining

The adhesive and metal piece of the metal substrate A32 is removed. Slit machining is performed by adopting a laser machine (FM20D laser machine produces by SHENZHEN GDLASER TECHNOLOGY CO., LTD) on region adhering the shielding member of the metal substrate (namely the slit region) (there are 9 slits formed, the slit has a shape of linear), the slit has a width of 30 microns and a length of 70 millimeters, a distance between two adjacent slits is 1.5 millimeters. A power of the laser is 150W, a cutting speed is 100mm/s, a frequency is 50kHz and a wave length is 355 nanometers. Then a metal substrate A33 with slit is obtained.

### 3) Second injection molding

The second injection molding, adopting the same method of the first injection molding, is performed on a non-injection molded region (namely slit region) of the inner surface of the metal substrate A33 so as to form a second plastic layer (having a thickness of 0.8millimeters). Thus a metal substrate A34 combined with a flat and consistent plastic layer is obtained, the second plastic layer is fully filled in the slit.

### 4) Forming surface decorative layer via anodic oxidation

The metal substrate A34 is subjected to alkali etching, water washing, acid etching and water washing treatment, then the metal substrate A34 is dipped in an electrolytic bath containing H₂SO₄ aqueous solution having a concentration of 180g/L, taking the metal substrate A34 as anode and a stainless steel as cathode, the anodic oxidation is performed under a voltage of 15V, a current density of 1A/dm², a temperature of 19 Celsius degrees for 40 minutes. And then the metal substrate A34 is taken out and cleaned up via ultrasonic wave to avoid hidden acid in the slit which may influence following dyeing. Then the slit is totally covered by the decorative layer and invisible by naked eyes.

The metal substrate A34 after anodic oxidation is dipped in an acidic dye solution (dyestuff: TAC BLACK-SLH, purchased from OKUNO CHEMICAL INDUSTRIES CO., LTD) to conduct dyeing for 10 minutes, the acidic dye solution has a concentration of 5g/L, a pH of 5.5, a temperature of 50 Celsius degrees. Then the metal substrate A34 is taken out and cleaned.

Then the metal substrate A34 is dipped in a sealant (NiSO₄ aqueous solution, having a concentration of 10g/L) for 20 minutes, under a temperature of 95Celsius degrees. And then the metal substrate A34 is cleaned via pure water having a temperature of 90 Celsius degrees, and baking under 60 Celsius degrees for 15 minutes. Then the decorative layer obtained has a thickness of 16 microns. Thus a communication equipment metal shell A35, which has an effect of integrated appearance and a decorative layer having a flat surface, is obtained.

### Example 4

### 1) First injection molding

A metal substrate A42 combined with a first plastic layer is obtained according the method of step 1) of Example 1.

### 2) Slit machining

The adhesive and plastic piece of the metal substrate A42 is removed. Slit machining is performed by adopting a copper wire having a diameter of 0.02millimeters under a feed speed of 12millimters per minutes, a peak current of 1.2A, a pulse width of 4µs, a pulse spacing of 16µs and a machining voltage of 70V on region adhering the shielding member of the metal substrate (namely the slit region) (there are 9 slits formed, the slit has a shape of linear), the slit has a width of 60 microns and a length of 30 millimeters, a distance between two adjacent slits is 1 millimeter. Then a metal substrate A43 with slit is obtained.

### 3) Second injection molding

The second injection molding, adopting the same method of the first injection molding, is performed on a non-injection molded region (namely slit region) of the inner surface of the metal substrate A43 so as to form a second plastic layer (having a thickness of 0.6millimeters). Thus a metal substrate A44 combined with a flat and consistent plastic layer is obtained, the second plastic layer is fully filled in the slit.

### 4) Forming surface decorative layer via micro-arc oxidation

The metal substrate A44 is subjected to ungrease treatment, then the metal substrate A44 is dipped in an micro-arc oxidation electrolyte (containing 40g/L of sodium hexametaphosphate, 8g/L of sodium silicate, and 12g/L of ammonium metavanadate), taking the metal substrate A44 as anode and a stainless steel as cathode, the micro-arc oxidation is performed under a voltage of 0V to 600V, a current density of 5A/dm², a temperature of 25 Celsius degrees for 40 minutes. And then the metal substrate A44 is taken out and cleaned via pure water. Then the slit is totally covered by the decorative layer, and the surface slit is not detectable by hand-touching.

The metal substrate A44 is dipped in a hot pure water having a temperature of 85 Celsius degrees for 5 minutes so as to perform sealing, and then the metal substrate A44 is taken out and blow-dried. Thus a communication equipment metal shell A45, which has an effect of integrated appearance and a decorative layer having a flat surface, is obtained (the decorative layer has a thickness of 35microns).

### Example 5

### 1) First injection molding

A metal substrate A52 combined with a first plastic layer is obtained according the method of step 1) of Example 1.

### 2) Slit machining

The adhesive and plastic piece of the metal substrate A52 is removed. Then the metal substrate A52 is placed in a vacuum chamber, and the vacuum chamber is vacuumed to 10⁻³-10⁻⁴Pa. Under a current of 8mA, an electron beam is gathered via a magnetic aggregation system to form a spot having a diameter of 15 microns such that the power density reaches 10⁷W/cm², a slit (there are 9 slits formed, the slit has a shape of linear) is formed on the metal shell A52, the slit has a width of 15 microns and a length of 70 millimeters, a distance between two adjacent slits is 0.6 millimeters. Then a metal substrate A53 with slit is obtained.

### 3) Second injection molding

The second injection molding, adopting the same method of the first injection molding, is performed on a non-injection molded region (namely slit region) of the inner surface of the metal substrate A53 so as to form a second plastic layer (having a thickness of 0.6millimeters). Thus a metal substrate A54 combined with a flat and consistent plastic layer is obtained, the second plastic layer is fully filled in the slit.

### 4) Forming surface decorative layer via electrophoresis

The metal substrate A54 is subjected to alkali etching, water washing, acid etching and water washing treatment, then the metal substrate A54 is dipped in an electrophoretic paint (obtained by dissolving an acrylic resin (purchased from SHIMIZU CO., LTD) in a colloidal form in water, the acrylic resin has a content of 7wt%) as a cathode to perform the electrophoresis for 120 seconds under conditions of: pH of the electrophoretic paint on cathode is 4.5, a temperature of 23Celsius degrees, a voltage of 35V so as to form an electrophoresis coating on surface of the metal substrate A54, then the metal substrate A54 is washed in water for 120 seconds to remove residual liquid on surface of the electrophoresis coating so as to obtain a metal shell after electrophoretic. Then the slit is totally covered by the electrophoretic coating and invisible by naked eyes. Finally, the metal substrate A54 is placed in an oven having a temperature of 175 Celsius to bake for 50 minutes. Thus a communication equipment metal shell A55, which has an effect of integrated appearance and a decorative layer (electrophoretic coating) having a flat surface, is obtained (the electrophoretic coating has a thickness of 30microns).

### Example 6

A metal substrate 64 combined with a flat and consistent plastic layer is obtained according the method of step 1) and step 2) of Example 1. A decorative layer is formed via spraying, the conditions of the spraying include: static high voltage of 70kV, a static current of 15µA, a velocity pressure of 0.4Mpa, a atomizing pressure of a0.4Mpa, a transporting velocity of 5m/min, a curing temperature of 180 Celsius degrees, and a curing time of 1 hour. Thus a communication equipment metal shell A65, which has an effect of integrated appearance and a coating layer having a flat surface, is obtained (the coating layer has a thickness of 40microns).

It could tell from these examples above, with the method of the present disclosure, a shielding member is firstly adhering on a region of the inner surface of the metal substrate on where a slit will be formed, then a first injection molding is performed on the non-slit region of the inner surface of the metal substrate to form a plastic layer on the non-slit region of the inner surface of the metal substrate, so as to provide a supporting for the following slit machining, then deformation of the slit during slit machining may be avoided. The shield member is removed after the first injection molding and then slit machining is carried out, then a metal residual may be discharged during slit machining through a vacancy reserved before the first injection molding, thus the metal residual could be prevented from staying in the slit, which may influence transmitting of electromagnetic wave. In addition, the vacancy reserved may be filled through the second injection molding, which could prevent the slit from being deformed during the process of surface decorating, thus flat and consistent of the appearance of the metal shell could be guaranteed so as to obtain an effect of integrated appearance.

Although explanatory examples stated above have been shown and described in detail, it may be appreciated by those skilled in the art that the above examples cannot be construed to limit the present disclosure, various simple modifications could be made within technical spirit and principles of the present disclosure, those simple modifications all fall into the protection scope of the present disclosure.

In addition, it should be noted that, each specific technical feature described in the example stated above, under no contradiction, could be combined via any appropriate manner, in order to avoid unnecessary repetition, various possible combination manners are not illustrated in the present disclosure.

In addition, each different example of the present disclosure could also be combined with each other without departing from spirit and principles of the present disclosure, which should also be deemed as content of present disclosure.

## Claims

1. A method of manufacturing a metal shell of communication equipment, the method comprising steps of:
1) performing a first injection molding on a non-slit region of an inner surface of a metal substrate;
2) forming at least one slit on a slit region of the inner surface of the metal substrate; and
3) performing a second injection molding on the slit region of the inner surface of the metal substrate.

2. The method of claim 1, wherein the first injection molding is performed by adhering a shielding member on the slit region of the inner surface of the metal substrate, and then performing injection molding on the non-slit region of the inner surface of the metal substrate.

3. The method of claim 1 or claim 2, wherein the first injection molding is performed under conditions of: an injection pressure of about 1600bar to about 2400bar, a maintaining pressure of about 800bar to about 1400bar, a temperature of upper and lower mould of about 80 Celsius degrees to about 150 Celsius degrees, and an injection time of about 0.5 seconds to about 2 seconds.

4. The method of any one of claims 1-3, further comprising: prior to performing the first injection molding, performing a first roughing treatment on the non-slit region of the inner surface of the metal substrate.

5. The method of claim 4, wherein the first roughing treatment is performed by:
a) contacting the inner surface of the metal substrate with a hydrochloric acid solution having a concentration of about 2wt% to about 20wt% for about 1 minute to about 5 minutes under a temperature of about 10 Celsius degrees to about 35 Celsius degrees, and then dipping the metal substrate under water for about 1 minute to about 5 minutes; and
b) repeating the step a) for 2 to 10 times.

6. The method of any one of claims 1-5, wherein the slit has a width of about 5 microns to about 100 microns.

7. The method of any one of claims 1-6, wherein the slit has a length of about 2 millimeters to about 300 millimeters.

8. The method of any one of claims 1-7, wherein a distance between two adjacent slits is about 0.1 millimeters to about 30 millimeters.

9. The method of any one of claims 1-8, wherein, in step 2), the slit is formed by cutting the metal substrate.

10. The method of claim 9, wherein a method of the cutting is at least one selected from a group consisting of laser cutting, electron beam cutting, waterjet cutting and wire-electrode cutting.

11. The method of any one of claims 1-10, wherein the second injection molding is performed under conditions of: an injection pressure of about 1600bar to about 2400bar, a maintaining pressure of about 800bar to about 1400bar, a temperature of upper and lower mould of about 80 Celsius degrees to about 150 Celsius degrees, and an injection time of about 0.5 seconds to about 2 seconds.

12. The method of any one of claims 1-11, further comprising: prior to performing the second injection molding, performing a second roughing treatment on the slit region of the inner surface of the metal substrate.

13. The method of claim 12, wherein the second roughing treatment is performed by:
a) contacting the inner surface of the metal substrate with a hydrochloric acid solution having a concentration of about 2wt% to about 20wt% for about 1 minute to about 5 minutes under a temperature of about 10 Celsius degrees to about 35 Celsius degrees, and then dipping the metal substrate under water for about 1 minute to about 5 minutes; and
b) repeating the step a) for 2 to 10 times.

14. The method of any claims 1-13, further comprising: forming a decorative layer on an outer surface of the metal substrate.

15. The method of claim 14, wherein the decorative layer is formed via electrophoresis, micro-arc oxidation, anodic oxidation, hard anodic oxidation, spraying or combinations thereof.

16. A metal shell of communication equipment, wherein the metal shell of communication equipment is obtained via the method of any one of claims 1-15.
